# EUROPEAN PATENT APPLICATION

(11) **EP 4 379 916 A1**
(43) Date of publication of application: **05.06.2024**
(21) Application number: 23212902.3
(22) Date of filing: 29.11.2023
(51) Int. Cl.: H01M 50/107, H01M 6/50, H01M 6/02

(54) **COPY CELL**

(30) Priority: 30.11.2022 KR 20220164288
(71) Applicant: Samsung SDI Co., Ltd., Yongin-si, Gyeonggi-do 17084 (KR)
(72) Inventor: Jeong, A Reum, 17084 Yongin-si, Gyeonggi-do (KR); Lee, Choong Hoon, 17084 Yongin-si, Gyeonggi-do (KR); Kim, Myung Chul, 17084 Yongin-si, Gyeonggi-do, (KR)
(74) Representative: Gulde & Partner

(57) **Abstract**

A copy cell having a first region made of a first material, a second region outside the first region and made of a second material, and a third region outside the second region and made of the first material, for simulating thermal characteristics of a real battery cell.

## Description

### BACKGROUND

### 1. Field

The present disclosure relates to a copy cell for simulating thermal characteristics of a real battery cell.

### 2. Description of the Related Art

When a thermal test of a real battery cell is conducted, the test is conducted at a Crate in a low range. This is due to the danger of testing a real battery cell at a high temperature range. A thermal test may be performed using a copy cell instead of a real battery in the case that it is dangerous to test the real battery at high temperatures or if the real battery cell is unavailable due to being in the development stage. In this case, the test is generally conducted by copying only the shape with metal such as aluminum or plastic. However, a copy cell using only a single material has the same thermal characteristics, e.g., thermal conductivity, in all directions and thus may not completely simulate the thermal characteristics of an anisotropic battery cell.

### SUMMARY

Embodiments are directed to copy cell including a first region made of a first material and having a cylindrical shape, a second region located outside the first region and made of a second material, and a third region located outside the second region and made of the first material. This arrangement allows higher flexibility when adjusting the thermal conductivity of the copy cell in order to mimic conventional (real) battery cells.

In embodiments, the first material may be a metal, including stainless steel, and the second material may be an insulating material, including plastic or urethane. In embodiments, the second material may be in the form of a foam or a gel.

In embodiments of the copy cell, the first region may have a first thickness that may be a distance from a center of the copy cell to an outer surface of the first region, the second region may have a second thickness that may be a distance from the outer surface of the first region to an outer surface of the second region, and the ratio of the first thickness to the second thickness may be about 3:1.

In embodiments of the copy cell, the first thickness of the first region is about 8 mm to 14 mm. Preferably the first thickness of the first region is about 9 to 11 mm, most preferred 10 mm.

In embodiments of the copy cell, the third region has a third thickness that is a distance from the outer surface of the second region to the outer surface of the third region, and the ratio of the first thickness to the third thickness may be about 0.9: 1 to about 2:1, preferably about 1:1, most preferred (1.03:1).

In embodiments of the copy cell, the copy cell has a diameter and a height wherein a diameter-to-height ratio is about 1:1.7 to about 1:1.8.

In embodiments of the copy cell, the first region may have a thermal conductivity of about 13 W/mK to about 18 W/mK.

In embodiments of the copy cell, the second region may have a thermal conductivity of about 0.3 W/mK.

In embodiments of the copy cell, a thermal conductivity in the thickness direction of the copy cell may be about 0.6 W/mK to about 2.4 W/mK.

In embodiments of the copy cell, a thermal conductivity in the thickness direction of the copy cell may be about 1.3 W/mK. This thermal conductivity is particularly suitable to mimic thermal conductivity of a conventional battery cell.

In embodiments of the copy cell, the diameter of the copy cell 100 may be 46 mm.

### BRIEF DESCRIPTION OF DRAWINGS

Features will become apparent to those of skill in the art by describing in detail exemplary embodiments with reference to the attached drawings in which:
FIG. 1 a perspective view showing a copy cell according to an embodiment of the present disclosure;
FIG. 2 is a perspective, cross-sectional view of the copy cell shown in FIG. 1;
FIG. 3A is a table showing the thermal conductivity of a copy cell in the thickness direction according to the ratio of a first thickness of a first region to a second thickness of a second region;
FIG. 3B is a graph of the table of FIG. 3A; and
FIG. 4 is a table showing the thermal conductivity of a copy cell in the thickness direction according to the thermal conductivity of the first region and the thermal conductivity of the second region.

### DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art. Like reference numerals refer to like elements throughout.

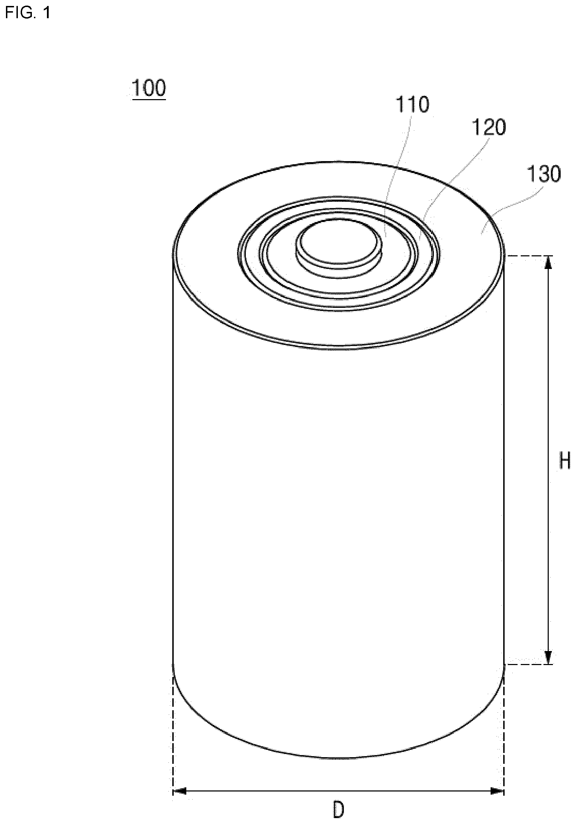

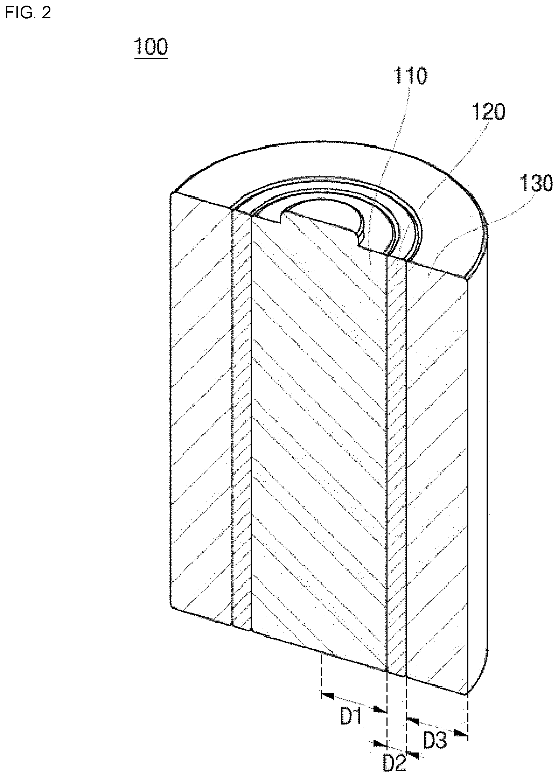

Referring to FIGS. 1 and 2, a copy cell 100 according to an embodiment of the present disclosure may include a first region 110 located at the center, a second region 120 located outside the first region 110, and a third region 130 located outside the second region 120.

The copy cell 100 may be formed in a cylindrical shape. The ratio of the diameter D to the height H of the copy cell 100 may be about 1:1.7 to about 1:1.8. In some embodiments, the ratio of the diameter D to the height H of the copy cell 100 may be 1:1.739 (D:H = 1:1.739). That is, the height H of the copy cell may be relatively greater than the diameter D of the copy cell 100.

The first region 110 may be located in the most central region of the copy cell 100 and may be formed in a substantially cylindrical shape. The first region 110 may be made of a first material. The first material may be a metal, and may include, e.g., stainless steel (SUS, steel use stainless). The thermal conductivity of the first material may be about 13 W/mK to 18 W/mK. The first region 110 may have a first thickness D1 that is a distance from the center of the copy cell 100 to the outer surface of the first region 110. Here, the first thickness D1 may be the radius of the first region 110.

The second region 120 may be formed outside the first region 110. The second region 120 may surround the outer surface of the first region 110 and may have a ring shape in cross section. The second region 120 may be made of a second material different from the first material forming the first region 110. The second material may be an insulating material such as, e.g., plastic or urethane. Said insulating material may for instance be a polymer, preferably a polyurethane. In some embodiments the second material may be in the form of a foam or a gel. For instance, the second material may be in the form of a polymer foam or a polymer gel, preferably a polyurethane foam or a polyurethane gel. The thermal conductivity of the second material may be about 0.3 W/mK. Preferably, the thermal conductivity of the second material may be about 0.29 W/mK to about 0.31 W/mK. The second region 120 may have a second thickness D2 that may be a distance from the outer surface of the first region 110 to the outer surface of the second region 120. The ratio of the second thickness D2 of the second region 120 to the first thickness D1 of the first region 110 may be 1:3 (D2:D1 = 1:3).

The third region 130 may be formed outside the second region 120. The third region 130 may surround the outer surface of the second region 120 and may have a ring shape in cross section. The third region 130 may be made of the first material, that is, the same material as the first region 110. The third region 130 may have a third thickness D3 that may be a distance from the outer surface of the second region 120 to the outer surface of the third region 130, i.e., the outer surface of the copy cell 100.

As described above, in the copy cell 100 according to the present disclosure, the second region 120 may be made of the second material and may be formed between the first region 110 and the third region 130. The third region 130 may have a thermal conductivity of about 13 W/mK to about 18 W/mK, since the first region 110 and the third region are made of the first material. The first region 110 and the third region may be made of the first material, that is, the same material, thereby adjusting the thermal characteristics, e.g., thermal conductivity, in the thickness direction of the copy cell 100.

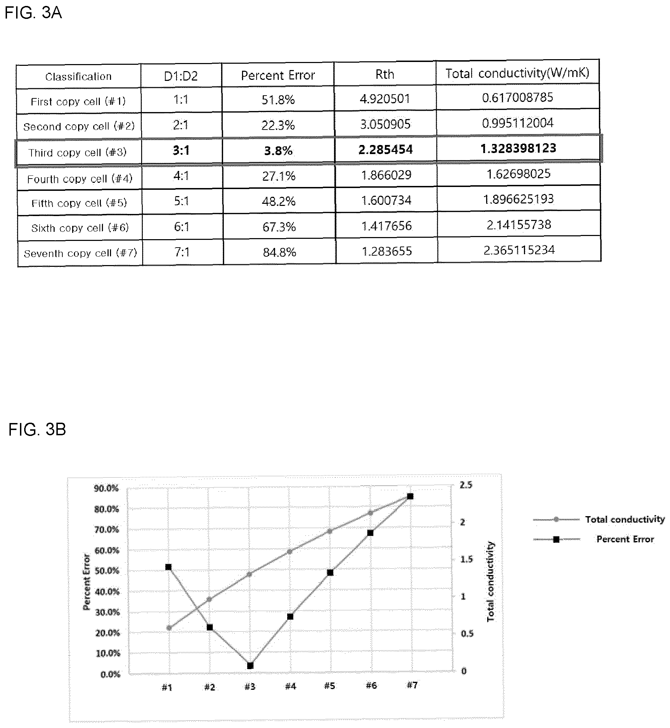

FIG. 3A is a table showing the thermal conductivity in the thickness direction of a copy cell according to the ratio of the first thickness D1 of the first region 110 to the second thickness D2 of the second region 120. FIG. 3B is a graph showing the table of FIG. 3A.

The table and graph shown in FIGS. 3A and 3B will be described with reference to the copy cell 100 shown in FIGS. 1 and 2.

In the present disclosure, in order to fabricate a copy cell 100 similar to a real battery cell, i.e., having thermal conductivity of 1.3 W/mK in the thickness direction, the thickness of the first region 110 and the second region 120 are changed and thermal conductivity of the copy cell 100 measured. Here, the diameter of the copy cell 100 is 46 mm, and the first thickness D1 of the first region 110 is about 8 to 14 mm.

The experimental method for measuring the thermal conductivity of the copy cell 100 may be guided by Korean standards, such as ISO 8301, ISO 8302, ASTM C117, ASTM C518, and KS L 9016. For example, the thermal conductivity measurement method of the copy cell 100 may adopt a plate-direct method (or a guarded hot plate apparatus method) used in ISO 8302, ASTM C177, or KS L 9016. In the plate-direct method, a temperature difference between both sides of a measuring material may be set to be 10 °C or more, and the thermal conductivity may be determined by measuring the temperature of both sides of an object tested upon reaching a steady state with power supplied to a main hot plate. In addition, for example, the experimental method for measuring the thermal conductivity of the copy cell 100 may adopt a plate-comparison method, or a heat flow meter apparatus method, used in ISO 8301, ASTM C518, or KS L 9016. In the plate-comparison method, a temperature difference between both sides of a measuring material may be set to be 10 °C or more. A test object is considered to be in a steady state if a test object reaches a state in which the temperature difference between sides does not change by more than 1% per 30 minutes, the output of a heat flow meter does not change by more than 2% per 30 minutes, and the temperatures of both surfaces of the test object do not change in the same direction. Thermal conductivity may be obtained by measuring the values after reaching the steady state.

Referring to FIGS. 3A and 3B, copy cells #1 to #7 with diameter of 46 mm were prepared as follows:
(1) a first copy cell (#1) having a ratio of the first thickness D1 of the first region 110 to the second thickness D2 of the second region 120 of 1:1 and with a first thickness D1 of 8 mm,
(2) a second copy cell (#2) having a ratio of the first thickness D1 of the first region 110 to the second thickness D2 of the second region 120 of 2:1 and with a first thickness D1 of 9 mm,
(3) a third copy cell (#3) having a ratio of the first thickness D1 of the first region 110 to the second thickness D2 of the second region 120 of 3:1 and with a first thickness D1 of 10 mm,
(4) a fourth copy cell (#4) having a ratio of the first thickness D1 of the first region 110 to the second thickness D2 of the second region 120 of 4:1 and with a first thickness D1 of 11 mm,
(5) a fifth copy cell (#5) having a ratio of the first thickness D1 of the first region 110 to the second thickness D2 of the second region 120 of 5:1 and with a first thickness D1 of 12 mm,
(6) a sixth copy cell (#6) having a ratio of the first thickness D1 of the first region 110 to the second thickness D2 of the second region 120 of 6:1 and with a first thickness D1 of 13 mm, and
(7) seventh copy cell (#7) having a ratio of the first thickness D1 of the first region 110 to the second thickness D2 of the second region 120 of 7:1 and with a first thickness D1 of 14 mm.

**Table 1 shows thicknesses D1 to D3 of copy cells #1 to #7 each with diameter of 46 mm.**

| | D1:D2 | D1 (mm) | D2 (mm) | D3 (mm) | D1:D3 |
|---|---|---|---|---|---|
| #1 | 1:1 | 8 | 8.0 | 7.0 | 1.1:1 |
| #2 | 2:1 | 9 | 4.5 | 9.5 | 0.9:1 |
| #3 | 3:1 | 10 | 3.3 | 9.7 | 1:1 |
| #4 | 4:1 | 11 | 2.8 | 9.3 | 1.2:1 |
| #5 | 5:1 | 12 | 2.4 | 8.6 | 1.4:1 |
| #6 | 6:1 | 13 | 2.2 | 7.8 | 1.7:1 |
| #7 | 7:1 | 14 | 2.0 | 7.0 | 2:1 |

In addition, as shown in FIG. 3A, when the total conductivity of each respective copy cells #1 to #7 was measured, the thermal conductivity were as follows:
(#1) was about 0.617 W/mK,
(#2) was about 0.995 W/mK,
(#3) was about 1.328 W/mK,
(#4) was about 1.626 W/mK,
(#5) was about 1.896 W/mK,
(#6) was about 2.141 W/mK, and
(#7) was about 2.365 W/mK.

That is, the copy cell having a thermal conductivity the most similar to the thermal conductivity of the real battery cell was the third copy cell (#3) having the ratio 3:1 between the first thickness D1 of the first region 110 to the second thickness D2 of the second region 120.

In addition, referring to FIG. 3B, by expressing the difference between the measured conductivity of each copy cell (#1-#7) and the thermal conductivity of the real battery cell as a percentage (Percent Error), it can be seen that the difference in thermal conductivity between the real battery cells and the third copy cell (#3) had the least Percent Error and therefore was closest in value at 3.8%.

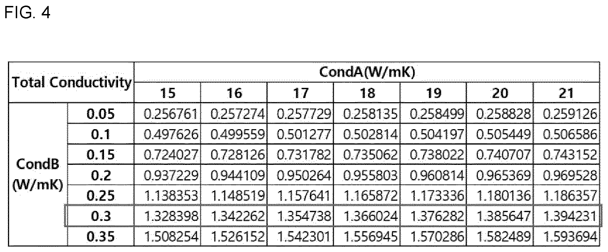

FIG. 4 is a table showing the thermal conductivity in the thickness direction of a copy cell according to the thermal conductivity (CondA) of the first region 110 and the thermal conductivity (CondB) of the second region 120. Here, the thermal conductivity in the thickness direction of the copy cell 100 was measured while changing the thermal conductivities of the first region 110 and the second region 120 and keeping the thickness ratio of the first region 110 and the second region 120 the same at 3:1 (D1:D2).

Referring to FIG. 4, it can be seen that the thermal conductivity (CondB) of the second region 120, rather than the thermal conductivity (CondA) of the first region 110, determines the thermal conductivity in the thickness direction of the copy cell 100. In some embodiments, as shown in FIG. 4, if the thermal conductivity of the second region 120 is 0.3 W/mK, the thermal conductivity of the first region 110 can be varied between 15 W/mK and 21 W/mK and the thermal conductivity in the thickness direction of the copy cell 100 will stay around 1.3 W/mK. On the other hand, as shown in FIG. 4, if the thermal conductivity of the second region is varied by even 0.05 w/mK, the thermal conductivity in the thickness direction of the copy cell will deviate from around 1.3 W/mk. Notably, 1.3 W/mK is the thermal conductivity in the thickness direction most similar to that of the real battery cell.

As described above, in the copy cell for the test of a battery cell test according to an embodiment of the present disclosure, by forming a second region made of a second material between a first region and a third region made of the same material, that is, the first material, thermal conductivity in the thickness direction of the copy cell can be controlled.

By way of summation and review, the copy cell 100 according to an embodimentt of the present disclosure may have a shape similar in appearance to a real battery cell. During a thermal test of the battery cell, if using the real battery cell, there are risks such as, at a high temperature range, ignition of the battery cell. Therefore, in the present disclosure, an alternative to the risk of using a real battery cell in a thermal test is presented in the form of a copy cell 100 having thermal characteristics similar to the real battery cell

In general, if a copy cell is manufactured with a single material, the thermal conductivity in the height direction (or vertical direction) of the copy cell can be adjusted so as to be similar to that of a real battery cell, but the thermal conductivity in the thickness direction (or horizontal direction) of the copy cell cannot be adjusted so as to be similar to a real battery cell. Specifically, as the size of a cylindrical battery cell is increased, side cooling is required. However, if the thermal conductivity in the thickness direction of the copy cell does not match that of the real battery cell, the copy cell cannot simulate the thermal behavior of the real battery cell. Therefore, in the present disclosure, by forming the second region 120 made of the second material between the first region 110 and the third region 130 made of the same material, that is, the first material, the thermal conductivity in the thickness direction of the copy cell 100 may be adjusted similar to that of the real battery cell.

Examples of the present disclosure are provided to more completely explain the present disclosure to those skilled in the art, and the following examples may be modified in various other forms. The present disclosure, however, may be embodied in many different forms and should not be construed as being limited to the example (or exemplary) embodiments set forth herein. Rather, these example embodiments are provided so that this disclosure will be thorough and complete and will convey the aspects and features of the present disclosure to those skilled in the art.

In addition, in the accompanying drawings, sizes or thicknesses of various components are exaggerated for brevity and clarity. Like numbers refer to like elements throughout. As used herein, the term "and/or" includes any and all combinations of one or more of the associated listed items. In addition, it will be understood that when an element A is referred to as being "connected to" an element B, the element A can be directly connected to the element B or an intervening element C may be present therebetween such that the element A and the element B are indirectly connected to each other.

The terminology used herein is for the purpose of describing particular embodiments only and is not intended to be limiting of the disclosure. As used herein, the singular forms are intended to include the plural forms as well, unless the context clearly indicates otherwise. It will be further understood that the terms that the terms "comprise" and/or "comprising," when used in this specification, specify the presence of stated features, numbers, steps, operations, elements, and/or components, but do not preclude the presence or addition of one or more other features, numbers, steps, operations, elements, components, and/or groups thereof.

It will be understood that, although the terms first, second, etc. may be used herein to describe various members, elements, regions, layers and/or sections, these members, elements, regions, layers and/or sections should not be limited by these terms. These terms are only used to distinguish one member, element, region, layer and/or section from another. Thus, for example, a first member, a first element, a first region, a first layer and/or a first section discussed below could be termed a second member, a second element, a second region, a second layer and/or a second section without departing from the teachings of the present disclosure.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the element or feature in the figures is turned over, elements described as "below" or "beneath" other elements or features would then be oriented "on" or "above" the other elements or features. Thus, the exemplary term "below" can encompass both an orientation of above and below.

Here, the same reference numerals are attached to parts having similar configurations and operations throughout the specification. In addition, when a part is said to be electrically coupled to another part, this includes not only a case where it is directly connected but also a case where it is connected with another element interposed therebetween.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A copy cell (100), comprising:
a first region (110) made of a first material and having a cylindrical shape;
a second region (120) located outside the first region (110) and made of a second material; and
a third region (130) located outside the second region (120) and made of the first material.

2. The copy cell according to claim 1, wherein the first material is a metal.

3. The copy cell according to claim 2, wherein the first material is stainless steel.

4. The copy cell according to one of the preceding claims, wherein the second material is an insulating material.

5. The copy cell according to claim 4, wherein the second material is plastic or urethane.

6. The copy cell according to claims 4 or 5, wherein the second material is in the form of a foam or a gel.

7. The copy cell according to one of the preceding claims, wherein:
the first region (110) has a first thickness (D1) that is a distance from a center of the cell to an outer surface of the first region (110);
the second region (120) has a second thickness (D2) that is a distance from the outer surface of the first region (110) to an outer surface of the second region (120); and
the ratio of the first thickness (D1) to the second thickness (D2) is about 3:1.

8. The copy cell according to claim 7, wherein first thickness D1 of the first region 110 is about 8 mm to 14 mm.

9. The copy cell according to claim 7 or 8, wherein third region (130) has a third thickness (D3) that is a distance from the outer surface of the second region (120) to the outer surface of the third region (130); and
the ratio of the first thickness (D1) to the third thickness (D3) is about 1:1.

10. The copy cell according to one of the preceding claims, wherein the copy cell has a height (H) and a diameter (D), and a diameter-to-height ratio (D:H) of the copy cell is about 1:1.7 to about 1:1.8.

11. The copy cell according to one of the preceding claims , wherein the first region (110) has a thermal conductivity of about 13 W/mK to about 18 W/mK.

12. The copy cell according to one of the preceding claims, wherein the second region (120) has a thermal conductivity of about 0.3 W/mK.

13. The copy cell according to claim 9, wherein the third region (130) has a thermal conductivity of about 13 W/mK to about 18 W/mK.

14. The copy cell according to one of the preceding claims, wherein a thermal conductivity in a thickness direction of the copy cell is about 0.6 W/mK to about 2.4 W/mK.

15. The copy cell according to claim 14, wherein a thermal conductivity in a thickness direction of the copy cell is about 1.3 W/mK.
